(19) Europäisches Patentamt / European Patent Office / Office européen des brevets

(11) **EP 2 697 659 B1**

(12) **EUROPÄISCHE PATENTSCHRIFT**

(45) Veröffentlichungstag und Bekanntmachung des Hinweises auf die Patenterteilung:
**18.03.2015   Patentblatt 2015/12**

(21) Anmeldenummer: **11715697.6**

(22) Anmeldetag: **14.04.2011**

(51) Int Cl.:
*G01R 15/16* ^(2006.01)      *G01R 31/312* ^(2006.01)
*G01R 29/12* ^(2006.01)      *G01R 15/14* ^(2006.01)
*G01R 19/00* ^(2006.01)      *G01R 19/155* ^(2006.01)
*G01R 19/165* ^(2006.01)      *G01R 27/26* ^(2006.01)

(86) Internationale Anmeldenummer:
**PCT/EP2011/055950**

(87) Internationale Veröffentlichungsnummer:
**WO 2012/139650 (18.10.2012 Gazette 2012/42)**

(54) **VORRICHTUNG ZUR BERÜHRUNGSLOSEN BESTIMMUNG EINES ELEKTRISCHEN POTENTIALS EINES OBJEKTS, STROMZANGE SOWIE VERFAHREN**

DEVICE FOR THE CONTACTLESS DETERMINATION OF AN ELECTRICAL POTENTIAL OF AN OBJECT, CURRENT PROBE, AND METHOD

DISPOSITIF DE DÉTERMINATION SANS CONTACT D'UN POTENTIEL ÉLECTRIQUE D'UN OBJET, PINCE AMPÈREMÉTRIQUE ET PROCÉDÉ ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.02.2014   Patentblatt 2014/08**

(73) Patentinhaber: **Siemens Aktiengesellschaft**
**80333 München (DE)**

(72) Erfinder:
• **SCHIMMER, Jürgen**
**90473 Nürnberg (DE)**
• **MAKUTH, Jens**
**90537 Feucht (DE)**

• **SCHEIBNER, Dirk**
**90473 Nürnberg (DE)**

(56) Entgegenhaltungen:
EP-A2- 0 398 396          EP-A2- 1 249 706
WO-A1-2008/009906          DE-A1- 4 123 309
FR-A1- 2 924 814          US-A- 4 611 207
US-A- 5 473 244          US-A1- 2006 058 694
US-A1- 2007 086 130          US-A1- 2007 164 723
US-A1- 2011 148 393          US-B1- 6 531 880

• PRANCE R J ET AL: "Non-contact VLSI imaging using a scanning electric potential microscope", MEASUREMENT SCIENCE AND TECHNOLOGY, IOP, BRISTOL, GB, Bd. 9, Nr. 8, 1. August 1998 (1998-08-01), Seiten 1229-1235, XP020064553, ISSN: 0957-0233, DOI: 10.1088/0957-0233/9/8/014

EP 2 697 659 B1

**Beschreibung**

Die Erfindung betrifft eine Vorrichtung zur berührungslosen Bestimmung eines elektrischen Potentials eines Objekts mit einer Elektrode. Die Erfindung betrifft auch eine Stromzange mit einer solchen Vorrichtung. Schließlich betrifft die Erfindung ein Verfahren zum berührungslosen Bestimmen eines elektrischen Potentials eines Objekts.

Es ist bekannt, den Stromfluss durch ein Objekt berührungslos zu messen. Dies kann über induktive Kopplung, den Hall-Effekt oder den GMR(Giant Magneto Resistance)-Effekt erfolgen. Um berührungslos elektrische Leistung messen zu können, ist jedoch neben der berührungslosen Strommessung auch ein Verfahren zur berührungslosen Potentialmessung erforderlich. Die berührungslose Potentialmessung, insbesondere hoher Spannungen, ist v.a. im Bereich Smart Metering, Smart Grid und Response-Demand-Strategien von besonderer Bedeutung.

Eine Möglichkeit hierfür bieten so genannte Elektrofeldmeter. Diese nutzen den Effekt der Influenz, um über die ermittelte elektrische Feldstärke auf die zu bestimmende Spannung schließen zu können. Dafür müssen jedoch der Abstand zwischen dem Objekt, dessen Potential bestimmt werden soll, und der Messelektrode des Elektrofeldmeters sowie das Material (Dielektrikum) zwischen Messelektrode und Objekt in der Messkapazität exakt bekannt sein. Um mit einem Elektrofeldmeter auch Gleichspannungen messen zu können, wird in der Regel zwischen der Messelektrode und dem Objekt ein Shutter (Feldblende) in Form eines Choppers (Flügelrad) eingesetzt.

Für die Bestimmung reiner Wechselspannungen sind auch kapazitive Spannungsteiler nutzbar, wobei hier ebenfalls die Koppelkapazität zwischen einer Referenzelektrode und dem zu messenden Potential bekannt sein muss.

Beide Verfahren bzw. Vorrichtungen (Elektrofeldmeter und kapazitiver Spannungsteiler) setzen eine genaue Kenntnis der Ankopplung an die zu messende Spannung voraus, insbesondere des Abstands zwischen Messelektrode und Messobjekt. Insofern sind diese bekannten Verfahren für nur temporäre Messvorgänge oder nachträgliche Messinstallationen ungeeignet. Elektrofeldmeter und kapazitive Spannungsteiler werden für präzise Messungen fest installiert und in der Einbauumgebung kalibriert. Bei Handmessgeräten ist eine exakte Kenntnis der Geometrie und stofflichen Beschaffenheit (Leitungsisolation, Luft, Gas, Betauung, etc.) des Messaufbaus nötig. Dazu werden bei handelsüblichen Elektrofeldmetern zum Beispiel spezielle Abstandshalter benutzt. Abstandshalter haben jedoch den Nachteil, dass sie insbesondere für die Potentialbestimmung elektrisch isolierter Leitungen nicht direkt auf dem leitenden Material aufsitzen und damit den Abstand nur unzureichend genau einstellen. Zudem kann die Art des isolierenden Materials nicht berücksichtigt werden. Reicht diese Präzision der bekannten berührungslosen Potentialmessverfahren nicht aus, muss üblicherweise kontaktierend gemessen werden.

Die EP 1 249 706 A2 beschreibt ein kontaktloses Spannungsmessverfahren zum Messen einer an einen Leiter angelegten Wechselspannung unter Verwendung einer Detektionssonde mit einer Detektionselektrode, welche einen Teil einer Oberfläche einer Isolation zum Isolieren des Leiters abdecken kann, und einer Schirmelektrode zum Abdecken der Detektionselektrode, und einen Oszillators zur Ausgabe eines Signals, wobei jeweils ein Ende eines Kernkabels und eines Hüllkabels eines Schirmkabels mit der Detektionselektrode bzw. mit der Schirmelektrode verbunden ist und wobei der Einflüss einer potentialfreien Kapazität im Wesentlichen durch die Herstellung eines imaginären Kurzschlusszustandes zwischen den jeweils anderen Enden des Kernkabels und des Hüllkabels ausgelöscht wird.

Die WO 2008/009906 A1 beschreibt einen Sensor zum Bestimmen eines elektrischen Potenzials mit mindestens einer Detektionselektrode, die zur kapazitiven Kopplung mit einer im Test befindlichen Probe und zum Erzeugen eines Messsignals angeordnet ist, einem Oszillator, der zum Erzeugen eines Oszillator-Ausgangs angeordnet ist, welcher eine der Frequenz des Messsignals entsprechende Frequenz aufweist und einer Rückkopplungseinrichtung, die auf den Oszillator-Ausgang reagiert, um ein Rückkopplungs-Referenzsignal zu erzeugen, um eine kohärente Rückkopplung am Eingang des Sensor-Verstärkers anzulegen.

Aus der US 2006/058694 A1 ist ein elektrodynamischer Sensor mit einem Paar Eingangssonden zum Detektieren von elektrischen Potentialen, die aus einem zu testenden Objekt stammen, und zum Erzeugen von Detektionssignalen, bekannt. Zudem umfasst der Sensor einen Elektrometer, der einen Verstärker aufweist und eingerichtet ist, um die Detektionssignale zu empfangen und Messsignale zu liefern.

Die US 6 531 880 B1 beschreibt einen berührungslosen Kabeltester mit einem Sensor zum Erfassen eines elektrischen Felds, das von einem Kabel ausgegeben wird. Dabei wird das Sensorsignal mit vorbestimmten Schwellwerten verglichen, um die durch das Kabel fließende elektrische Energie zu bestimmen.

Des Weiteren beschreibt die US 2007/086130 A1 eine Vorrichtung zum Bestimmen eine Wechselspannung in einem Leiter mit einer ersten und einer zweiten Gruppen von kapazitiven Spannungssensoren, die jeweils kreisförmig um den Leiter angeordnet sind.

Die US 5 473 244 A offenbart eine Vorrichtung zum berührungslosen Messen der Spannung, des Stroms und der Leistung in einem elektrischen Leiter. Die Vorrichtung umfasst eine Anordnung aus kapazitiven Sensoren, mit denen ein Sensorsignal in Abhängigkeit von dem durch den elektrischen Leiter erzeugten elektrischen Feld bereitstellbar ist. Dabei kann auch eine Gleichspannung in dem elektrischen Leiter erfasst werden, indem eine Elektrode der kapazitiven Sensoren kontinuierlich bewegt wird.

Die FR 2 924 814 A und die EP 0 398 396 A2 beschreiben Systeme zur Messung elektrischen Spannungen. Die Systeme umfassen kapazitiven Sensoren, mit denen die elektrischen Spannungen in einem Mehrphasensystem erfasst werden können.

Aus der US 4 611 207 A ist eine Vorrichtung zum Messen einer elektrischen Spannung bekannt, die ein ringförmiges Gehäuse aufweist, das an einer Hochspannungs-Freileitung angeordnet werden kann.

Es ist Aufgabe der Erfindung, ein Verfahren sowie eine Vorrichtung bereitzustellen, mit denen eine berührungslose Potentialmessung auch bei zunächst unbekannter Koppelkapazität möglich ist.

Diese Aufgabe wird durch eine Vorrichtung, welche die Merkmale des Patentanspruchs 1 aufweist, eine Stromzange mit den Merkmalen des Patentanspruchs 7, sowie ein Verfahren, welches die Merkmale des Patentanspruchs 8 aufweist, gelöst.

Die erfindungsgemäße Vorrichtung dient zur berührungslosen Bestimmung eines elektrischen Potentials eines Objekts und umfasst eine Elektrode sowie einen Potentialsteller, welcher mit der Elektrode elektrisch verbunden ist zum Verändern eines an der Elektrode anliegenden Bezugspotentials auf einen Endwert, bei dem ein zwischen der Elektrode und einem Bezugspotentialträger fließender Umladestrom verschwindet, wenn die Elektrode von dem Objekt beabstandet ist, und zum Bestimmen des elektrischen Potentials des Objekts aus dem Endwert, und einer Einrichtung zum periodischen Verändern einer Anordnung einer Feldblende, die zwischen dem Objekt und der Elektrode angeordnet ist, so dass zu ersten Zeitpunkten ein elektrisches Feld zwischen der Elektrode und dem Objekt ausgebildet ist und zu zweiten Zeitpunkten das elektrische Feld (E) durch die Feldblende abgeschirmt ist, wobei mit dem Potentialsteller ein zeitlich konstantes elektrisches Potential des Objekts bestimmbar ist..

Unter Kenntnis des Endwerts bei Messung des Verschwindens des elektrischen Felds kann unmittelbar auf das zu bestimmende elektrische Potential geschlossen werden. Auf dieser Art ist ein Kompensationsverfahren geschaffen, bei dem die Elektrode insbesondere auf gerade so ein elektrisches Potential gehoben wird, dass der Raum zwischen der Elektrode und dem Objekt feldfrei wird. Die Kompensation kann durch Anhebung des Potentials an der Messelektrode auf die zu bestimmende Spannung des Objekts erfolgen. Für die Messung ist insbesondere keine Kenntnis des Abstands bzw. der Koppelkapazität zwischen Elektrode und Objekt erforderlich. Eine aufwändige Bestimmung des Abstands oder einer Dielektrizitätskonstante kann entfallen. Dennoch ist die Art der Messung sehr zuverlässig und hochgenau. Für das Aufbringen der zur Kompensation nötigen Spannungen an der Elektrode sind nur geringste Leistungen notwendig. Eine technische Realisierung ist einfach zu implementieren. Eine direkte Kontaktierung des zu messenden Objekts ist nicht erforderlich. Damit erfolgen nur minimale Störungen bzw. Eingriffe an dem Messobjekt. Die Vorrichtung erlaubt auch bei einem nur schwer zugänglichen Objekt die Bestimmung von dessen Potential.

Vorzugsweise ist der Potentialsteller dazu ausgebildet, eine zeitliche Veränderung eines elektrischen Ladezustands der Elektrode zu bestimmen und in Abhängigkeit des bestimmten Ladezustands das Bezugspotential so zu verändern, dass bei Erreichen des Endwerts die zeitliche Veränderung des Ladezustands verschwindet. Die zeitliche Veränderung des elektrischen Ladezustands kann insbesondere durch Messung eines Umladestroms bestimmt werden, welcher zwischen der Elektrode und einem Bezugspotentialträger fließt. Im Falle der Feldfreiheit zwischen Objekt und Elektrode ist ein statischer Zustand erreicht und es fließen keine Umladeströme mehr. Die Messung des Umladestroms erlaubt damit aussagekräftige Rückschlüsse auf das elektrische Feld zwischen Elektrode und Objekt und der Kompensationsfall kann sehr leicht identifiziert werden. Wird beispielsweise der Umladestrom null, muss nur noch die an der Elektrode anliegende Spannung gemessen werden bzw. abgelesen werden und das elektrische Potential des Objekts ist bestimmt.

Vorzugsweise umfasst die Vorrichtung einen Verstärker mit einem ersten und einem zweiten Eingang sowie einem Ausgang, wobei die Elektrode mit dem ersten Eingang und der Potentialsteller mit dem zweiten Eingang und der erste Eingang mit dem Ausgang elektrisch verbunden ist. Auf diese Art ist eine zweckmäßige sowie einfach und unkompliziert zu realisierende Messanordnung geschaffen, durch welche das Bezugspotential der Elektrode sehr einfach einstellbar ist. Es sind besonders zuverlässige Messungen des elektrischen Potentials des Objekts möglich.

Vorzugsweise umfasst der Potentialsteller eine Regelvorrichtung, welche dazu ausgebildet ist, das Potential am Ausgang zu messen und in Abhängigkeit des gemessenen Potentials das Bezugspotential am zweiten Eingang so einzustellen, dass sich der Wert des am Ausgang gemessenen Potentials bezüglich seines absoluten Betrags bis auf den Wert null verringert. Der Wert des Potentials am Ausgang kann insbesondere als Spannung gegenüber einer Erdung gemessen werden. Durch die Regelvorrichtung ist es möglich, den jeweils herrschenden Wert des Bezugspotentials so nachzuführen, dass das Bezugspotential bis auf den Potentialwert des Objekts erhöht wird. Auf diese Art ist eine zuverlässige als auch sehr schnelle Messmethode geschaffen, da der Endwert rasch erreicht wird.

Die Feldblende kann insbesondere in Form eines Shutters und/oder Flügelrads (Choppers) ausgebildet sein. Es ist eine zuverlässige Möglichkeit geschaffen, DC-Potentiale eines Objekts zu bestimmen. Vorzugsweise erfolgt dann die Veränderung des an der Elektrode anliegenden Bezugspotentials deutlich schneller als es der Veränderung der elektrischen Feldabschirmung durch die Feldblende entspricht. Die Messfrequenz ist also insbesondere deutlich größer als die Rotationsfrequenz eines Flügelrads.

Vorzugsweise ist dann die Feldblende mit dem zweiten Eingang elektrisch verbunden. Da in diesem Fall die Feldblende insbesondere dasselbe Bezugspotential wie die Elektrode aufweist, ist eine besonders gute Feldfreiheit geschaffen, sodass ein aussagekräftiger Untergrund als Referenz bereitsteht, um das elektrische Potential des Objekts korrekt zu bestimmen.

Vorzugsweise ist die Elektrode von einem Elektrofeldmeter und/oder einem kapazitiven Spannungsteiler umfasst.

Eine erfindungsgemäße Stromzange dient zur berührungslosen Bestimmung eines durch das Objekt fließenden elektrischen Stroms und umfasst eine erfindungsgemäße Vorrichtung sowie eine Auswerteeinheit, welche dazu ausgebildet ist, aus einem mit der Stromzange bestimmten Wert für den elektrischen Strom und einem mit der Vorrichtung bestimmten Wert des elektrischen Potentials eine elektrische Leistung zu ermitteln. Eine aus dem Stand der Technik bekannte Stromzange für die berührungslose Strommessung wird auf diese Art um die Funktion einer berührungslosen Spannungsmessung ergänzt. Auf diese Weise ergibt sich ein besonderer synergetischer Effekt, da mithilfe der vorgesehenen Auswerteeinheit aus dem berührungslos bestimmten Wert für den elektrischen Strom und dem berührungslos bestimmten Wert für das elektrische Potential nunmehr auch die elektrische Leistung berührungslos bestimmbar ist. Hierbei ist weder für die Strom- noch für die Spannungsmessung eine genaue Kenntnis der Ankopplung der Stromzange an das Messobjekt erforderlich. Es ist eine Vorrichtung zur komplett berührungslosen Leistungsmessung geschaffen.

Ein erfindungsgemäßes Verfahren dient zum berührungslosen Bestimmen eines elektrischen Potentials eines Objekts und umfasst die folgenden Schritte:

- Bereitstellen einer Elektrode, welche von dem Objekt beabstandet ist;
- Verbinden der Elektrode mit einem Bezugspotential;
- Verändern der Bezugspotentials auf einen Endwert, bei dem ein zwischen der Elektrode (2) und einem Bezugspotentialträger fließender Umladestrom verschwindet;
- Bestimmen des elektrischen Potentials des Objekts durch Messen des Endwerts;
- periodisches Verändern einer Anordnung einer Feldblende, die zwischen dem Objekt und der Elektrode angeordnet ist, so dass zu ersten Zeitpunkten ein elektrisches Feld zwischen der Elektrode und dem Objekt ausgebildet ist und zu zweiten Zeitpunkten das elektrische Feld durch die Feldblende abgeschirmt ist; und
- Bestimmen eines zeitlich konstanten elektrischen Potentials des Objekts.

Vorzugsweise ist das elektrische Potential des Objekts zeitlich veränderlich und hierbei durch eine erste Veränderungsrate charakterisierbar. Dann wird vorzugsweise das Bezugspotential auf den Endwert mit einer zweiten Rate verändert, welche größer als die erste Rate ist. Im Falle eines Objekts, welches von einem Wechselstrom durchflossen wird, ändert sich auch das elektrische Potential an dem Objekt mit der Zeit. Dann ist es vorteilhaft, wenn eine Regelung vorgesehen ist, durch welche die Bezugsspannung an der Elektrode zur Kompensation des elektrischen Feldes schnell genug nachgeführt wird und mit dem Wechselpotential an dem Objekt Schritt hält. In diesem Fall werden Messfehler besonders gering gehalten.

Die mit Bezug auf die erfindungsgemäße Vorrichtung dargestellten bevorzugten Ausführungsformen und deren Vorteile gelten entsprechend für die erfindungsgemäße Stromzange sowie das erfindungsgemäße Verfahren.

Anhand von Ausführungsbeispielen wird die Erfindung im Folgenden näher erläutert. Es zeigen:

FIG 1A    eine Stromzange gemäß dem Stand der Technik;

FIG 1B    eine Stromzange gemäß einem Ausführungsbeispiel der vorliegenden Erfindung;

FIG 2    eine schematische Darstellung einer Vorrichtung zur Bestimmung eines unbekannten Potentials mittels Kompensation eines elektrischen Felds; und

FIG 3    eine zu FIG 2 korrespondierende Anordnung, jedoch mit einer Feldblende zur Bestimmung einer Gleichspannung.

In den Figuren sind gleiche oder funktionsgleiche Elemente mit den gleichen Bezugszeichen versehen.

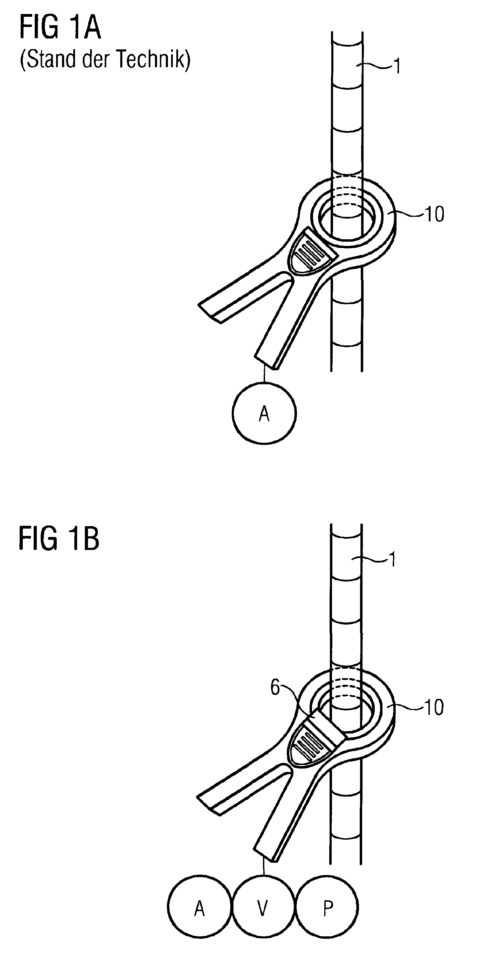

FIG 1A zeigt eine Stromzange 10 zur berührungslosen Strommessung an einer stromdurchflossenen Leitung 1. Die Stromzange 10 wird hierzu um die Leitung 1 gelegt, berührt diese jedoch nicht. Das in einem Kreis dargestellte "A" symbolisiert, dass mit der Stromzange 10 gemäß dem Stand der Technik ausschließlich eine Strommessung möglich ist.

Dagegen ist durch eine Stromzange 10 gemäß einem Ausführungsbeispiel der vorliegenden Erfindung eine Möglichkeit geschaffen, neben der Strommessung auch eine berührungslose Messung von Spannung und damit Leistung zu realisieren. Dies ist durch die in Kreisen dargestellten Buchstaben "V" und "P" symbolisiert. Hierfür ist in der Stromzange 10 eine Spannungsmessvorrichtung 6 vorgesehen, die im Folgenden näher erläutert wird.

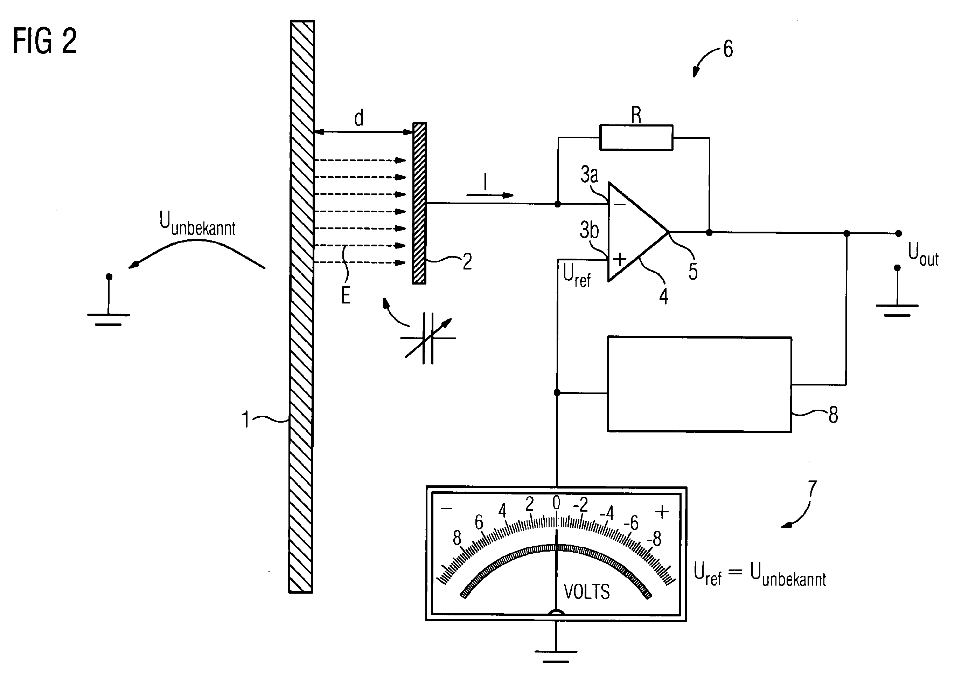

FIG 2 zeigt eine Leitung 1, welche ein Objekt darstellt, dessen elektrisches Potential $U_{unbekannt}$ bestimmt werden soll. Hierzu wird eine Messelektrode 2 in einem Abstand d von der Leitung 1 positioniert. Es sei betont, dass der Abstand d nicht bekannt ist. Die Messelektrode 2 ist über einen ersten Eingang 3a mit einem Verstärker 4 verbunden. An einem zweiten Eingang 3b des Verstärkers 4 liegt eine Referenzspannung $U_{ref}$ an, welche von einem Potentialsteller 7 bereitgestellt wird. Der Potentialsteller 7 ist zudem mit einem Ausgang 5 des Verstärkers 4 elektrisch verbunden. Über einen elektrischen Widerstand R ist dieser Ausgang 5 zudem mit dem ersten Eingang 3a elektrisch verbunden. Auf diese Art ist sichergestellt, dass die Referenzspannung $U_{ref}$ auch an der Messelektrode 2 anliegt. Schließlich sind Mittel bereitgestellt, mit denen eine Ausgangsspannung $U_{out}$ bestimmbar ist, welche zwischen dem Ausgang 5 und der Erde anliegt. Der Potentialsteller 7 umfasst schließlich auch noch einen Regler 8, auf dessen Funktion im Folgenden näher eingegangen werden soll.

In einfachster Näherung kann die durch die Leitung 1 und die Messelektrode 2 ausgebildete Kondensatoranordnung als Plattenkondensator mit einem zwischen den Platten herrschenden elektrischen Feld E beschrieben werden. Die Kapazität dieses Plattenkondensators betrage C; die Fläche der Messelektrode 2 betrage A; und die Dielektrizitätskonstante des Mediums zwischen der Leitung 1 und der Messelektrode 2 betrage ε. ΔU sei der Potentialunterschied zwischen der Messelektrode 2 und der Leitung 1. Dann gelten die folgenden physikalischen Zusammenhänge:

$$C = \frac{\varepsilon \cdot A}{d}$$

$$\Delta U = U_{unbekannt} - U_{ref}$$

$$E = \frac{\Delta U}{d}$$

$$I = C \frac{d(\Delta U)}{dt}$$

$$U_{out} = -R \cdot I = -RC \cdot \frac{d(\Delta U)}{dt}$$

I ist hierbei ein Umladestrom, welcher zwischen der Messelektrode 2 und dem Verstärker 4 fließt.

Das Messprinzip besteht nun darin, dass der Regler 8 das Bezugspotential $U_{ref}$ so weit anhebt, dass es dem zu messenden Potential $U_{unbekannt}$ entspricht. Hierfür kann vorgesehen sein, dass der Regler 8 eine Nachregelung von der Referenzspannung $U_{ref}$ auf die Ausgangsspannung $U_{out}=0$ vornimmt. Ist nämlich die Situation erreicht, dass die Ausgangsspannung $U_{out}$ verschwindet, also den Wert Null annimmt, dann entspricht die Referenzspannung $U_{ref}$ gerade dem Potential $U_{nbekannt}$. Die Referenzspannung $U_{ref}$ kann dann gemessen werden, wobei der Messwert genau dem Potentialwert $U_{unbekannt}$ entspricht. Aber auch ohne Messung ist gegebenenfalls bekannt, welche Referenzspannung $U_{ref}$ an dem Potentialsteller 7 eingestellt wurde, sodass sich aus dieser Kenntnis auf das Potential $U_{unbekannt}$ schließen lässt.

Alternativ kann jedoch auch vorgesehen sein, dass im Regler 8 der Umladestrom I erfasst wird und die Referenzspannung $U_{ref}$ so lange nachgeregelt wird, bis der Umladestrom I verschwindet, also den Wert Null erreicht.

Dieser Messidee liegt die Erkenntnis zugrunde, dass bei identischen Spannungen an Leitung 1 und Messelektrode 2 (also $U_{un\text{-}bekannt}=U_{ref}$) das elektrische Feld E zwischen Messelektrode 2 und Leitung 1 gerade verschwindet. Der Messvorgang besteht damit in einer Kompensation der zu messenden Spannung $U_{unbekannt}$ an der Messelektrode 2 (z.B. eines Elektrofeldmeters bzw. eines kapazitiven Spannungsteilers). Damit ist eine Spannungsmessung, also Messung von $U_{unbekannt}$, auch ohne exakte Kenntnis der räumlichen Anordnung der Messelektrode 2 möglich. Damit werden temporäre und nachträgliche Installationen ohne Kontaktierung der spannungsführenden Leitung 1 möglich.

Im Ausführungsbeispiel der FIG 2 ist $U_{nbekannt}$ eine Wechselspannung. Durch Influenzwirkung kommt es daher in der Messelektrode 2 ebenfalls zu einem AC-Umladestrom I. Die Regelung durch den Regler 8 muss dann deutlich schneller sein als die höchsten zu messenden Frequenzanteile der zu messenden Spannung $U_{unbekannt}$, um die Spannung $U_{ref}$ korrekt nachführen zu können.

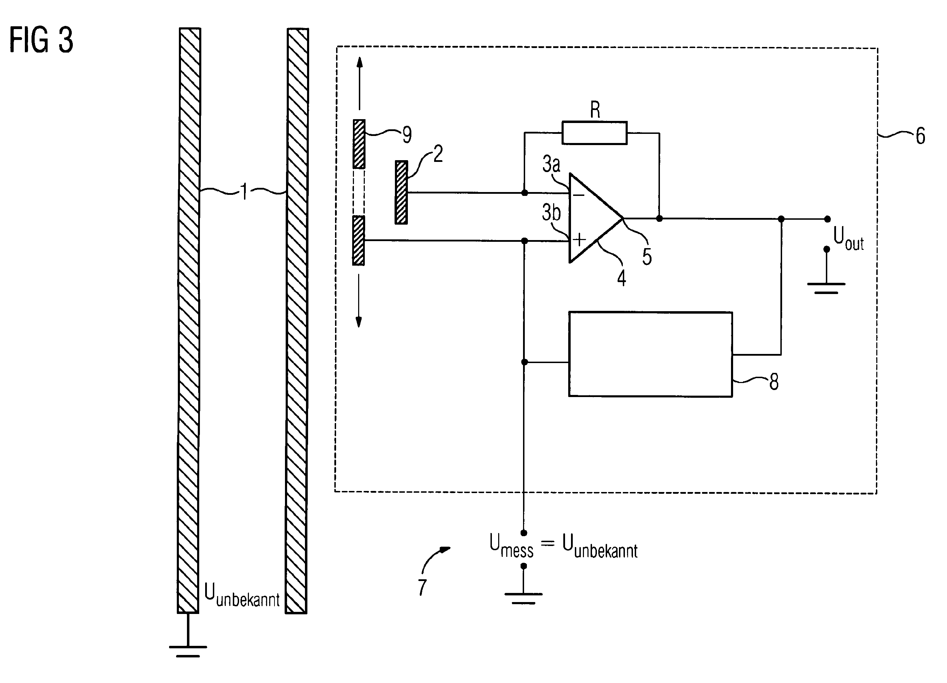

FIG 3 zeigt ein weiteres Ausführungsbeispiel, in dem im Wesentlichen die Anordnung der FIG 2 realisiert ist, jedoch um eine beweglich ausgebildete Feldblende 9 ergänzt. Die Feldblende 9 ist zwischen der Messelektrode 2 und der Leitung 1 angeordnet, welche sich auf einem zeitkonstanten Potential $U_{unbekannt}$ befindet. Die bewegliche Feldblende ist im Ausführungsbeispiel durch die Flügel eines Flügelrads eines sogenannten Choppers realisiert. Diese Flügel sind mit dem zweiten Eingang 3b verbunden und werden folglich ebenfalls auf die Referenzspannung $U_{ref}$ gelegt. Befindet sich ein Flügel zwischen Messelektrode 2 und Leitung 1, ist unabhängig vom Wert des Potentials $U_{unbekannt}$ das elektrische Feld E gegenüber der Messelektrode abgeschirmt und damit ein Messuntergrund bzw. eine Referenzsituation für den Messvorgang geschaffen. Ist dagegen das Flügelrad so verstellt, dass ein Spalt zwischen Messelektrode 2 und Leitung 1 freigegeben ist, so ist das elektrische Feld E nicht mehr abgeschirmt und es kann eine Messung wie in Zusammenhang mit FIG 2 beschrieben erfolgen. Auf diese Art ist es möglich, das beschriebene Verfahren auch für die Messung von Gleichspannungen $U_{nbekannt}$ einzusetzen. Die Regelfrequenz des Reglers 8 sollte dann höher als die Frequenz des Choppers bzw. der Feldblende 9 sein. Wie durch die Messspannung $U_{mess}$ angedeutet, wird im Ausführungsbeispiel der FIG 3 die jeweils eingestellte Referenzspannung $U_{ref}$ explizit gemessen: $U_{mess}=U_{ref}$.

Bezugszeichenliste

| 1 | Leitung |
|---|---|
| 2 | Messelektrode |
| 3a, 3b | Eingang |
| 4 | Verstärker |
| 5 | Ausgang |
| 6 | Spannungsmessvorrichtung |
| 7 | Potentialsteller |
| 8 | Regler |
| 9 | Feldblende |
| 10 | Stromzange |
| $U_{unbekannt}$ | Potential |
| d | Abstand |
| I | Umladestrom |
| R | Widerstand |
| $U_{out}$ | Ausgangsspannung |
| $U_{mess}$ | Messspannung |
| $U_{ref}$ | Referenzspannung |
| E | elektrisches Feld |
| A | Fläche |
| ε | Dielektrizitätskonstante |
| ΔU | Potentialunterschied |
| C | Kapazität |
| P | elektrische Leistung |

**Patentansprüche**

1. Vorrichtung (6) zur berührungslosen Bestimmung eines elektrischen Potentials ($U_{unbekannt}$) eines Objekts (1), mit einer Elektrode (2) und einem Potentialsteller (7), welcher mit der Elektrode (2) elektrisch verbunden ist, zum Verändern eines an der Elektrode (2) anliegenden Bezugspotentials ($U_{ref}$) auf einen Endwert ($U_{unbekannt}$), bei dem ein zwischen der Elektrode (2) und einem Bezugspotentialträger fließender Umladestrom verschwindet, wenn die Elektrode (2) von dem Objekt (1) beabstandet (d) ist, und zum Bestimmen des elektrischen Potentials ($U_{unbekannt}$) des Objekts (1) aus dem Endwert ($U_{unbekannt}$) **gekennzeichnet durch**
eine Einrichtung zum periodischen Verändern einer Anordnung einer Feldblende (9), die zwischen dem Objekt (1) und der Elektrode (2) angeordnet ist, so dass zu ersten Zeitpunkten ein elektrisches Feld (E) zwischen der Elektrode (2) und dem Objekt (1) ausgebildet ist und zu zweiten Zeitpunkten das elektrische Feld (E) **durch** die Feldblende abgeschirmt ist, wobei mit dem Potentialsteller (7) ein zeitlich konstantes elektrisches Potential ($U_{unbekannt}$) des Objekts (1) bestimmbar ist.

2. Vorrichtung (6) nach Anspruch 1, **dadurch gekennzeichnet, dass** mit dem Potentialsteller (7) anhand des Umladestroms eine zeitliche Veränderung eines elektrischen Ladezustands (I) der Elektrode (2) bestimmbar ist und in Abhängigkeit des bestimmten Ladezustands (I) das Bezugspotential ($U_{ref}$) so veränderbar ist, dass bei Erreichen des Endwerts ($U_{unbekannt}$) die zeitliche Veränderung des Ladezustands (I) verschwindet.

3. Vorrichtung (6) nach Anspruch 1 oder 2, **gekennzeichnet durch** einen Verstärker (4) mit einem ersten (3a) und einem zweiten Eingang (3b) sowie einem Ausgang (5), wobei die Elektrode (2) mit dem ersten Eingang (3a) und der Potentialsteller (7) mit dem zweiten Eingang (3b) und der erste Eingang (3a) mit dem Ausgang (5) elektrisch verbunden ist.

4. Vorrichtung (6) nach Anspruch 3, **dadurch gekennzeichnet, dass** der Potentialsteller (7) eine Regelvorrichtung (8) zum Messen des Potentials ($U_{out}$) am Ausgang (5) und zum Einstellen des Bezugspotentials ($U_{ref}$) am zweiten Eingang (3b) in Abhängigkeit des gemessenen Potentials ($U_{out}$), so dass sich der Wert des am Ausgang gemessenen Potentials ($U_{out}$) bezüglich seines Absolutbetrags ($|U_{out}|$) bis auf den Wert Null verringert, umfasst.

5. Vorrichtung (6) nach einem der Ansprüche 3 oder 4, **dadurch gekennzeichnet, dass** die Feldblende (9) mit dem zweiten Eingang (3b) elektrisch verbunden ist.

6. Vorrichtung (6) nach einem der vorhergehenden Ansprüche, **dadurch gekennzeichnet, dass** die Elektrode (2) von einem Elektrofeldmeter und/oder einem kapazitiven Spannungsteiler umfasst ist.

7. Stromzange (10) zur berührungslosen Bestimmung eines durch das Objekt (1) fließenden elektrischen Stroms, **gekennzeichnet durch** eine Vorrichtung (6) nach einem der vorhergehenden Ansprüche und eine Auswerteeinheit, welche dazu ausgebildet ist, aus einem mit der Stromzange (10) bestimmten Wert für den elektrischen Strom und einem mit der Vorrichtung (6) bestimmten Wert des elektrischen Potentials ($U_{unbekannt}$) eine elektrische Leistung (P) zu ermitteln.

8. Verfahren zum berührungslosen Bestimmen eines elektrischen Potentials ($U_{unbekannt}$) eines Objekts (1) mit den Schritten:

    - Bereitstellen einer Elektrode (2), welche von dem Objekt (1) beabstandet ist;
    - Verbinden der Elektrode (2) mit einem Bezugspotential ($U_{ref}$);
    - Verändern des Bezugspotentials ($U_{ref}$) auf einen Endwert ($U_{un-bekannt}$), bei dem ein zwischen der Elektrode (2) und einem Bezugspotentialträger fließender Umladestrom verschwindet;
    - Bestimmen des elektrischen Potentials ($U_{unbekannt}$) des Objekts (1) durch Messen des Endwerts ($U_{unbekannt}$);
    **gekennzeichnet durch**
    - periodisches Verändern einer Anordnung einer Feldblende (9), die zwischen dem Objekt (1) und der Elektrode (2) angeordnet ist, so dass zu ersten Zeitpunkten ein elektrisches Feld (E) zwischen der Elektrode (2) und dem Objekt (1) ausgebildet ist und zu zweiten Zeitpunkten das elektrische Feld (E) **durch** die Feldblende abgeschirmt ist; und
    - Bestimmen eines zeitlich konstanten elektrischen Potentials ($U_{unbekannt}$) des Objekts (1).

9. Verfahren nach Anspruch 8, **dadurch gekennzeichnet, dass** das elektrische Potential ($U_{nbekannt}$) des Objekts (1) zeitlich veränderlich und hierbei durch eine erste Veränderungsrate charakterisierbar ist, und das Bezugspotential ($U_{ref}$) auf den Endwert ($U_{unbekannt}$) mit einer zweiten Rate verändert wird, welche größer als die erste Rate ist.

**Claims**

1. Device (6) for the contactless determination of an electrical potential ($U_{unknown}$) of an object (1), comprising an electrode (2), and
a potentiometer (7), which is electrically connected to the electrode (2), for changing a reference potential ($U_{ref}$) present at the electrode (2) to an end value ($U_{unknown}$), at which a charge-reversal current flowing between the electrode (2) and a reference potential carrier disappears when the electrode (2) is spaced apart (d) from the object (1), and for determining the electrical potential ($U_{unknown}$) of the object (1) from the end value ($U_{nknown}$),
**characterized by**
a device for periodically changing an arrangement of a field stop (9), which is arranged between the object (1) and the electrode (2), so that, at first times, an electrical field (E) is formed between the electrode (2) and the object (1) and, at second times, the electrical field (E) is shielded by the field stop, wherein the potentiometer (7) can be used to determine a temporally constant electrical potential ($U_{unknown}$) of the object (1).

2. Device (6) according to Claim 1, **characterized in that** the potentiometer (7) can be used to determine, on the basis of the charge-reversal current, a change over time in an electrical state of charge (I) of the electrode (2) and to change the reference potential ($U_{ref}$) depending on the determined state of charge (I) such that, when the end value ($U_{nknown}$) is reached, the change over time in the state of charge (I) disappears.

3. Device (6) according to Claim 1 or 2, **characterized by** an amplifier (4) comprising a first input (3a) and a second input (3b) as well as an output (5), wherein the electrode (2) is electrically connected to the first input (3a), and the potentiometer (7) is electrically connected to the second input (3b), and the first input (3a) is electrically connected to the output (5).

4. Device (6) according to Claim 3, **characterized in that** the potentiometer (7) comprises a closed-loop control device (8), for measuring the potential ($U_{out}$) at the output (5) and for adjusting the reference potential ($U_{ref}$) at the second input (3b) depending on the measured potential ($U_{out}$) so that the value of the potential ($U_{out}$) measured at the output is reduced with respect to its absolute value ($|U_{out}|$) to the value zero.

5. Device (6) according to either of Claims 3 and 4, **characterized in that** the field stop (9) is electrically connected to the second input (3b).

6. Device (6) according to one of the preceding claims, **characterized in that** the electrode (2) is surrounded by an electric field meter and/or a capacitive voltage divider.

7. Current probe (10) for the contactless determination of an electrical current flowing through the object (1), **characterized by** a device (6) according to one of the preceding claims and an evaluation unit, which is designed to determine an electrical power (P) from a value, determined by the current probe (10), for the electrical current and a value, determined by the device (6), for the electrical potential ($U_{unknown}$).

8. Method for the contactless determination of an electrical potential ($U_{nknown}$) of an object (1), comprising the following steps:

  - providing an electrode (2), which is spaced apart from the object (1);
  - connecting the electrode object (2) to a reference potential ($U_{ref}$);
  - changing the reference potential ($U_{ref}$) to an end value ($U_{unknown}$), at which a charge-reversal current flowing between the electrode (2) and a reference potential carrier disappears;
  - determining the electrical potential ($U_{nknown}$) of the object (1) by measuring the end value ($U_{unknown}$);
  **characterized by**
  - periodically changing an arrangement of a field stop (9), which is arranged between the object (1) and the electrode (2), so that, at first times, an electrical field (E) is formed between the electrode (2) and the object (1) and, at second times, the electrical field (E) is shielded by the field stop; and
  - determining a temporally constant electrical potential ($U_{unknown}$) of the object (1).

9. Method according to Claim 8, **characterized in that** the electrical potential ($U_{nknown}$) of the object (1) is temporally variable and in this case can be **characterized by** a first rate of change, and the reference potential ($U_{ref}$) is changed to the end value ($U_{nknown}$) at a second rate, which is greater than the first rate.

**Revendications**

1. Dispositif (6) de détermination sans contact d'un potentiel électrique ($U_{inconnu}$) d'un objet (1), comprenant une électrode (2) et un actionneur de potentiel (7) qui est connecté électriquement à l'électrode (2), pour faire varier un potentiel de référence ($U_{ref}$) s'appliquant à l'électrode (2) et atteignant une valeur finale ($U_{inconnue}$) dans le cas de laquelle disparaît un courant de transfert de charge passant entre l'électrode (2) et un porteur de potentiel de référence quand l'électrode (2) est à distance (d) de l'objet (1), et ledit dispositif sert à déterminer, à partir de la valeur finale ($U_{inconnue}$), le potentiel électrique ($U_{inconnu}$) de l'objet (1), **caractérisé par** un dispositif servant à la modification périodique d'un agencement d'un diaphragme de champ (9) qui est disposé entre l'objet (1) et l'électrode (2), de sorte qu'à des premiers moments, un champ électrique (E) est configuré entre l'électrode (2) et l'objet (1) et, à des seconds moments, le champ électrique (E) est protégé par le diaphragme de champ, où un potentiel électrique ($U_{inconnu}$) de l'objet (1), constant dans le temps, peut être déterminé avec l'actionneur de potentiel (7).

2. Dispositif (6) selon la revendication 1, **caractérisé en ce qu'**une modification temporelle d'un état de charge électrique (I) de l'électrode (2) peut être déterminée avec l'actionneur de potentiel (7) à l'aide du courant de transfert de charge et, en fonction de l'état de charge déterminé (I), le potentiel de référence ($U_{ref}$) est modifiable de manière telle, que la modification temporelle de l'état de charge (I) disparaît une fois que la valeur finale ($U_{inconnue}$) est atteinte.

3. Dispositif (6) selon la revendication 1 ou 2, **caractérisé par** un amplificateur (4) comprenant une première (3a) et une seconde entrée (3b), ainsi qu'une sortie (5), où l'électrode (2) est connectée électriquement à la première entrée (3a), l'actionneur de potentiel (7) à la seconde entrée (3b) et la première entrée (3a) à la sortie (5).

4. Dispositif (6) selon la revendication 3, **caractérisé en ce que** l'actionneur de potentiel (7) comprend un dispositif de réglage (8) servant à mesurer le potentiel ($U_{out}$) au niveau de la sortie (5) et servant à régler le potentiel de référence ($U_{ref}$) au niveau de la seconde entrée (3b), en fonction du potentiel mesuré ($U_{out}$), de sorte que la valeur du potentiel ($U_{out}$) mesuré au niveau de la sortie diminue par rapport à sa valeur absolue ($|U_{out}|$), jusqu' à atteindre la valeur de zéro.

5. Dispositif (6) selon l'une des revendications 3 ou 4, **caractérisé en ce que** le diaphragme de champ (9) est connecté électriquement à la seconde entrée (3b).

6. Dispositif (6) selon l'une quelconque des revendications précédentes, **caractérisé en ce que** l'électrode (2) est entourée par un appareil de mesure de champ électrique et/ou par un diviseur de tension capacitif.

7. Pince ampèremétrique (10) de détermination sans contact d'un courant électrique traversant l'objet (1), **caractérisée par** un dispositif (6) selon l'une quelconque des revendications précédentes, et par une unité d'évaluation qui est conçue dans le but de calculer une puissance électrique (P) à partir d'une valeur pour le courant électrique, déterminée avec la pince ampèremétrique (10), et à partir d'une valeur du potentiel électrique ($U_{inconnu}$), déterminée avec le dispositif (6).

8. Procédé de détermination sans contact d'un potentiel électrique ($U_{inconnu}$) d'un objet (1), comprenant les étapes suivantes :

- la fourniture d'une électrode (2) qui est à distance de l'objet (1);
- la connexion de l'électrode à un potentiel de référence ($U_{ref}$)
- la modification du potentiel de référence ($U_{ref}$) atteignant une valeur finale ($U_{inconnue}$) dans le cas de laquelle disparaît un courant de transfert de charge passant entre l'électrode (2) et un porteur de potentiel de référence;
- la détermination du potentiel électrique ($U_{inconnu}$) de l'objet (1) en mesurant la valeur finale ($U_{inconnue}$);
**caractérisé par**
- une modification périodique d'un agencement d'un diaphragme de champ (9) qui est disposé entre l'objet (1) et l'électrode (2), de sorte qu'à des premiers moments, un champ électrique (E) est configuré entre l'électrode (2) et l'objet (1) et, à des seconds moments, le champ électrique (E) est protégé par le diaphragme de champ; et
- la détermination d'un potentiel électrique ($U_{inconnu}$) de l'objet (1), constant dans le temps.

9. Procédé selon la revendication 8, **caractérisé en ce que** le potentiel électrique ($U_{inconnu}$) de l'objet (1) est variable dans le temps et peut être caractérisé ici par un premier taux de modification, et le potentiel de référence ($U_{ref}$) est modifié avec un second taux pour atteindre la valeur finale ($U_{inconnue}$), second taux qui est supérieur au premier taux.

## FIG 1A
(Stand der Technik)

## FIG 1B

FIG 2

FIG 3

$U_{unbekannt}$

R

3a

3b

4

5

$U_{out}$

9

2

6

8

$U_{mess} = U_{unbekannt}$

7

EP 2 697 659 B1

EP 2 697 659 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1249706 A2
- WO 2008009906 A1
- US 2006058694 A1
- US 6531880 B1
- US 2007086130 A1
- US 5473244 A
- FR 2924814 A
- EP 0398396 A2
- US 4611207 A